Europäisches Patentamt

European Patent Office

Office européen des brevets

(19)

(11) EP 0 537 083 B1

(12) **FASCICULE DE BREVET EUROPEEN**

(45) Date de publication et mention
de la délivrance du brevet:
**02.04.1997 Bulletin 1997/14**

(51) Int Cl.6: **G11C 16/06**, G11C 7/00,
G11C 7/06

(21) Numéro de dépôt: **92402778.2**

(22) Date de dépôt: **09.10.1992**

(54) **Dispositif pour détecter le contenu de cellules au sein d'une mémoire, notamment une mémoire EPROM, procédé mis en oeuvre dans ce dispositif, et mémoire munie de ce dispositif**

Vorrichtung zum Lesen eines Speicherzelleinhalts, insbesondere für ein EPROM, Betriebsverfahren und Speicher mit einer solchen Vorrichtung

Memory cell content detection circuit, especially for an EPROM, method for its operation and memory provided with such a circuit

(84) Etats contractants désignés:
**DE FR GB IT**

(30) Priorité: **11.10.1991 FR 9112540**

(43) Date de publication de la demande:
**14.04.1993 Bulletin 1993/15**

(73) Titulaire: **SGS-THOMSON MICROELECTRONICS S.A.**
**94253 Gentilly Cédex (FR)**

(72) Inventeur: **Yero, Emilio**
**F-13100 Aix-en-Provence (FR)**

(74) Mandataire: **Schmit, Christian Norbert Marie et al**
**Cabinet Ballot-Schmit**
**7, rue Le Sueur**
**75116 Paris (FR)**

(56) Documents cités:
**EP-A- 0 087 006       EP-A- 0 270 750**
**EP-A- 0 359 561       EP-A- 0 399 820**
**SU-A- 809 269**

• **PATENT ABSTRACTS OF JAPAN vol. 4, no. 97 (E-18) 12 Juillet 1980 & JP-A-55 061 136**

## Description

La présente invention concerne un dispositif pour détecter le contenu des cellules incluses dans une mémoire, notamment une mémoire EPROM.

Elle vise également un procédé mis en oeuvre dans ce dispositif, ainsi qu'une mémoire munie de ce dispositif.

Le développement actuel de mémoires de très grandes capacités, notamment de type EPROM, s'est accompagné d'une augmentation des fréquences de travail des systèmes dans lesquels ces mémoires sont mises en oeuvre, et par conséquent de la recherche de temps d'accès toujours plus courts au contenu des cellules constituant ces mémoires. Or, pour minimiser le temps d'accès d'une mémoire, notamment une mémoire de type EPROM, il est essentiel de prépositionner l'amplificateur de détection normalement prévu pour permettre la lecture du contenu de chaque cellule dans un état dans lequel les entrées différentielles sont équilibrées.

Jusqu'à présent, dans les conceptions antérieures de cet amplificateur de détection, ce prépositionnement était effectué en utilisant une impulsion pour court-circuiter directement les entrées différentielles. Mais ceci présente l'inconvénient de générer des pics de courant parasites à la fois dans la colonne de référence et dans la ligne de bits, avec pour conséquence de perturber l'état du comparateur de courant et par conséquent de conduire à une augmentation du temps d'accès.

Le but de l'invention est de remédier à ces inconvénients en proposant un dispositif pour détecter le contenu des cellules d'une mémoire, notamment une mémoire EPROM, ces cellules étant organisées en un ensemble de lignes de bits, ce dispositif comprenant des moyens pour comparer un courant de référence associé à une colonne de référence et un courant de lecture appelé dans une cellule d'une ligne de bits et dont le contenu doit être lu, lesdits moyens de comparaison comprenant un élément résistif de référence et un élément résistif de lecture dans lesquels transitent respectivement lesdits courants de référence et de lecture, et qui sont reliés d'une part, à une source de tension d'alimentation, et d'autre part, respectivement à une entrée non inverseuse et à une entrée inverseuse d'un amplificateur différentiel délivrant en sortie une information de détection.

Selon l'invention, le dispositif comprend en outre des moyens pour relier sélectivement la sortie de l'amplificateur différentiel à son entrée inverseuse pendant une durée prédéterminée de précharge.

Ainsi, c'est l'étage différentiel lui-même qui est utilisé pour équilibrer les entrées différentielles, en passant d'un mode différentiel à un mode suiveur pendant une durée prédéterminée. Cela a aussi pour effet de compenser les dissymétries existant généralement dans les transistors d'entrée de l'étage différentiel.

En outre, du fait que l'intégralité du courant de précharge transite du côté de la ligne de bits, la colonne de référence n'est pas perturbée par l'opération de précharge, ce qui a pour effet d'améliorer la stabilité de la colonne de référence pendant l'opération de détection.

Suivant une forme de réalisation avantageuse, les moyens de liaison sélective comprennent des moyens de commutation commandés par un signal cyclique d'horloge de précharge.

Suivant un autre aspect de l'invention, le procédé pour détecter le contenu de cellules d'une mémoire, notamment de type EPROM, mis en oeuvre dans le dispositif selon l'invention, comprend, pour chaque séquence de lecture d'une cellule, une étape de précharge de ce dispositif, suivie d'une étape de lecture du contenu de ladite cellule comprenant une comparaison du courant circulant dans ladite cellule avec un courant de référence, cette comparaison étant réalisée par un amplificateur différentiel. Pendant l'étape de précharge, l'amplificateur différentiel est commuté en mode suiveur pendant un cycle d'horloge de précharge.

Suivant encore un autre aspect de l'invention, la mémoire permanente effaçable, notamment de type EPROM, intégrant les dispositifs selon l'invention, est caractérisée en ce qu'elle comprend des moyens de contrôle pour générer au cours d'un cycle d'horloge de précharge un signal pour commander les moyens pour relier sélectivement la sortie à l'entrée inverseuse de l'amplificateur différentiel de chacun des dispositifs de détection.

D'autres particularités de l'invention résulteront encore de la description ci-après.

Aux dessins annexés données à titre d'exemples non limitatifs :

- la figure 1 est une vue schématique d'un dispositif de détection selon l'invention;
- la figure 2 représente une forme pratique de réalisation de moyens de liaison sélective mis en oeuvre dans l'invention;
- la figure 3 est une vue synoptique de l'organisation d'une mémoire intégrant le dispositif selon l'invention.

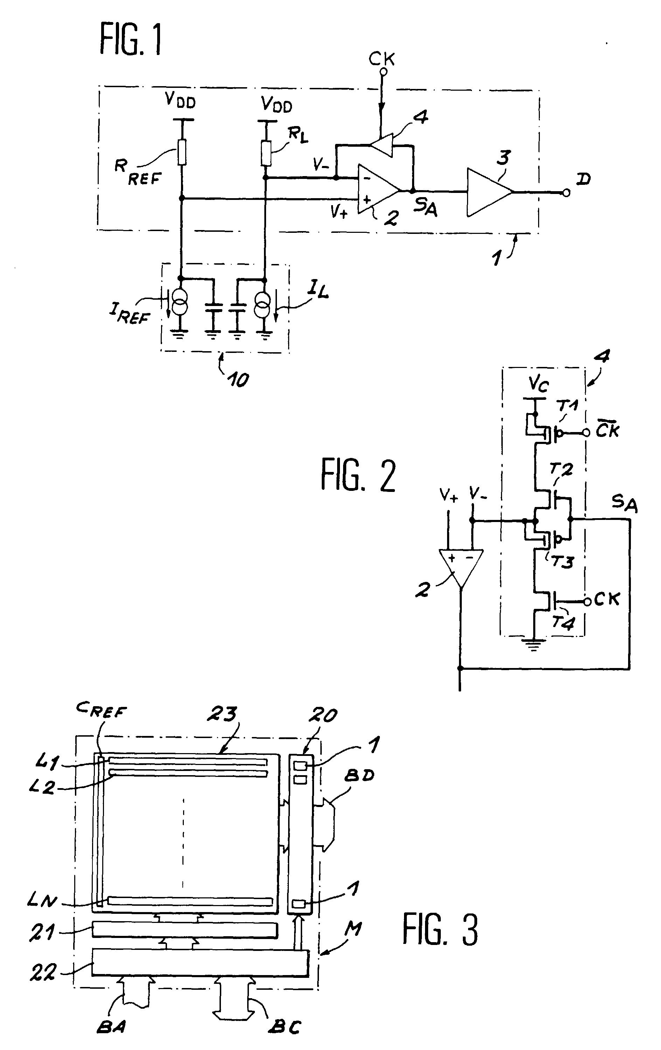

On va maintenant décrire plus en détail le dispositif de détection selon l'invention en référence aux figures 1 à 3, en même temps que le procédé mis en oeuvre dans ce dispositif.

Dans la forme de réalisation illustrée en figure 1, le dispositif de détection selon l'invention comprend un amplificateur différentiel 2 monté pour comparer un courant de référence $I_{REF}$ appelé dans une colonne de référence et représenté symboliquement par une source de courant de référence, à un courant de lecture $I_L$ appelé par une cellule mémoire 10 dont on veut précisément lire le contenu et qui est modélisée en figure 1 sous la forme d'une capacité et d'une source de courant. Chaque source de courant de référence et de lecture est respectivement reliée à une source de tension d'alimentation continue $V_{DD}$ via respectivement des éléments résistifs de référence et de lecture $R_{REF}$ et $R_L$, suivant des techniques bien connues dans le domaine de la fabrication des semi-conducteurs en technologie MOS. Par ailleurs, les éléments résistifs de référence et de lecture $R_{REF}$ et $R_L$ sont reliés respectivement aux entrée non inverseuse V+ et inverseuse V- de l'amplificateur différentiel 2 suivant un agencement bien connu de l'homme de métier dans le domaine de l'électronique. Selon l'invention, un commutateur 4 commandé par un signal d'horloge CK relie sélectivement la sortie de l'amplificateur différentiel 2 à son entrée inverseuse V-. Le signal de détection $S_A$ émis par l'amplificateur différentiel 2 est appliqué en entrée d'un amplificateur à haute impédance 3 qui génère une information logique D représentative du contenu de la cellule mémoire lue. Le dispositif de détection 1 selon l'invention présente ainsi une sortie en logique trois états rendant possible tout interfaçage de la mémoire au sein d'un système numérique.

En référence à la figure 2, le commutateur 4 peut être réalisé de manière avantageuse et en mettant en oeuvre des techniques bien connues, à partir de quatre transistors reliés en série, un premier transistor T1, de type PMOS, ayant sa source reliée à une source de tension continue Vc et son drain relié au drain d'un second transistor T2 de type NMOS dont la source est reliée à la source d'un troisième transistor T3 de type PMOS. Un quatrième transistor T4 de type NMOS a sa source reliée à la masse du dispositif et son drain relié au drain du troisième transistor T3. Il est à noter que les transistors T1 et T3 de type PMOS doivent avoir leur substrat relié à leur drain, afin notamment de minimiser leur tension de seuil.

On entend par transistor PMOS, un transistor MOS à canal P et par trandistor NMOS, un transistor MOS à canal N.

Un signal d'horloge $\overline{CK}$ généré par un générateur d'horloge extérieur (non représenté) est appliqué à la grille du quatrième transistor T4 tandis que son inverse logique CK est appliqué sur la grille du premier transistor T1. Le signal de détection $S_A$ est appliqué simultanément sur les grilles respectives des second et troisième transistors T2, T3, tandis que le point de jonction de la source du deuxième transistor T2 et de la source du troisième transistor T3 est reliée à l'entrée inverseuse V- de l'amplificateur différentiel 2.

Lorsque le signal horloge CK est au niveau logique haut, les transistors T4 et T1 sont passants. La sortie 5A de l'amplificateur différentiel 2 est alors reliée à son entrée inverseuse V- et l'amplificateur différentiel 2 est ainsi dans une configuration de suiveur. La tension de sortie $S_A$ est alors sensiblement égale au produit de la tension V+ par le rapport K/(K+1), si K est le gain de l'amplificateur différentiel 2. Or, comme K est généralement très grand devant 1, le signal Sa est sensiblement égal à la tension V+ correspondant à la colonne de référence. Cette configuration de suiveur est maintenue pendant le cycle de précharge commandé par une logique de contrôle interne à la mémoire. A l'issue de ce cycle de précharge, le commutateur 4 est alors placé en position ouverte, d'où une haute impédance entre l'entrée inverseuse V- et la sortie de l'amplificateur différentiel 2 qui remplit alors pleinement sa mission de comparateur puisqu'il n'est plus en contre-réaction.

Par ailleurs, il faut noter qu'avec l'invention, il n'y a aucun risque d'instabilité et d'oscillation pendant l'opération de précharge puisque le gain de réaction est égal à 1. L'amplificateur différentiel 2 se comporte alors comme un suiveur stabilisé par rebouclage négatif.

En outre, avec les dispositifs de détection de l'art antérieur, du fait des dissymétries inévitables existant entre les transistors d'entrée de l'amplificateur différentiel, une mise en court-circuit des deux entrées de l'amplificateur différentiel pouvait avoir pour effet une fausse lecture soit d'un 1, soit d'un 0. Avec le dispositif selon l'invention, le fait d'utiliser l'amplificateur lui-même pour l'équilibrage a pour effet de compenser automatiquement le déséquilibre précité entre transistors d'entrée, et les entrées de l'amplificateur différentiel sont alors polarisées au point de basculement de l'amplificateur.

Une mémoire M permanente effaçable programmable de type EPROM intégrant des dispositifs de détection selon l'invention, dont un exemple très simplifié de structure est représenté en figure 3, intègre un ensemble 23 de cellules mémoires organisées en lignes de bits L1, L2, Ln auxquelles est associée une colonne de référence $C_{REF}$. Une logique de contrôle et d'interface 22 traite les informations d'adresse reçues sur un bus d'adresse BA et celles de contrôle échangées sur un bus de contrôle BC. Une logique de décodage d'adresse assure le pointage de la ligne de bits concernée par une opération de lecture tandis qu'une logique de détection 20 intègre un ensemble de dispositifs de détection 1 selon l'invention qui génèrent des informations de lecture qui sont ensuite délivrées sur un bus de données BD. Il faut noter que l'ensemble des opérations d'adressage, de contrôle et d'interfaçage peut être réalisé suivant les techniques usuelles bien connues dans le domaine de la microélectronique.

Bien sûr, l'invention n'est pas limitée aux exemples qui viennent d'être décrits et on peut envisager d'autres aménagements et extensions sans sortir du cadre de l'invention. Ainsi, le commutateur permettant la liaison sélective de la sortie et de l'entrée inverseuse de l'amplificateur différentiel peut être réalisé de bien d'autres façons que celle qui vient d'être décrite. En outre, la présente invention peut être appliquée pour toute technologie de semi-conducteurs actuelle ou à venir, dès lors qu'il s'agit de détecter une information logique au sein d'une mémoire en mettant en oeuvre un amplificateur différentiel.

**Revendications**

1. Dispositif (1) pour détecter le contenu des cellules d'une mémoire (M), notamment une mémoire EPROM, ces cellules étant organisées en un ensemble de lignes de bits, le dispositif comprenant des moyens pour comparer un courant de référence ($I_{REF}$) associé à une colonne de référence ($C_{REF}$) et un courant de lecture ($I_L$) appelé dans une cellule d'une ligne de bits et dont le contenu doit être lu, lesdits moyens de comparaison comprenant un élément résistif de référence ($R_{REF}$) et un élément résistif de lecture ($R_L$) dans lesquels transitent respectivement lesdits courants de référence et de lecture, et qui sont reliés d'une part, à une source de tension d'alimentation ($V_{DD}$), et d'autre part, respectivement à une entrée non inverseuse (V+) et à une entrée inverseuse (V-) d'un amplificateur différentiel (2) délivrant en sortie un signal de détection ($S_A$), caractérisé en ce que le dispositif (1) comprend en outre des moyens (4) pour relier sélectivement la sortie de l'amplificateur différentiel (4) à son entrée inverseuse (V-) pendant une durée prédéterminée de précharge.

2. Dispositif (1) selon la revendication 1, caractérisé en ce que les moyens de liaison sélective (4) comprennent des moyens de commutation commandés par un signal cyclique (CK) d'horloge de précharge.

3. Dispositif (1) selon la revendication 2, caractérisé en ce qu'il comprend en outre des moyens d'amplification à haute impédance (3) placés en aval de l'amplificateur différentiel (2) pour générer à partir du signal de détection ($S_A$) émis par ledit amplificateur différentiel (2), une information logique de lecture (D).

4. Procédé pour détecter le contenu de cellules d'une mémoire (M), notamment de type EPROM, mis en oeuvre dans le dispositif (1) selon l'une des revendications précédentes, comprenant pour chaque séquence de lecture d'une cellule, une étape de précharge de ce dispositif (1), suivie d'une étape de lecture du contenu de ladite cellule comprenant une comparaison d'un courant de lecture ($I_L$) circulant dans ladite cellule avec un courant de référence ($I_{REF}$), cette comparaison étant réalisée par un amplificateur différentiel (2), caractérisé en ce que pendant l'étape de précharge, l'amplificateur différentiel (2) est commuté en mode suiveur pendant un cycle d'horloge de précharge.

5. Procédé selon la revendication 4, caractérisé en ce que pendant le cycle d'horloge de précharge, la sortie de l'amplificateur différentiel (2) est reliée à l'entrée inverseuse (V-) dudit amplificateur différentiel (2).

6. Mémoire permanente effaçable (M), notamment de type EPROM, intégrant des dispositifs (20, 1) selon l'une des revendications 1 à 3, caractérisé en ce qu'elle comprend des moyens de contrôle (22) pour générer au cours d'un cycle d'horloge de précharge un signal (CK) pour commander les moyens pour relier sélectivement la sortie et l'entrée inverseuse de l'amplificateur différentiel (2) de chacun des dispositifs de détection (1).

7. Mémoire permanente effaçable (M), notament du type EPROM équipée de moyens de lecture d'une cellule, caractérisée en ce que lesdits moyens mettent en oeuvre le procédé conforme à l'une des revendications 4 ou 5.

## Patentansprüche

1. Vorrichtung (1) zum Erfassen des Inhalts von Zellen eines Speichers (M), insbesondere eines EPROM-Speichers, die in einer Anordnung von Bitleitungen organisiert sind, wobei die Vorrichtung Vergleichsmittel umfaßt zum Vergleichen eines einer Referenzspalte ($C_{REF}$) zugeordneten Referenzstroms ($I_{REF}$) und eines in einer Zelle einer Bitleitung, deren Inhalt gelesen werden soll, abgerufenen Lesestroms ($I_L$), und wobei die Vergleichsmittel ein Referenzwiderstandselement ($R_{REF}$) und ein Lesewiderstandselement ($R_L$) umfassen, durch die jeweils der Refe-renzstrom bzw. der Lesestrom fließen und die einerseits mit einer Versorgungsspannungsquelle ($V_{DD}$) und andererseits jeweils mit einem nicht invertierenden (V+) bzw. einem invertierenden Eingang (V-) eines Differenzverstärkers (2) verbunden sind, der am Ausgang ein Erfassungssignal ($S_A$) ausgibt, **dadurch gekennzeichnet**, daß die Vorrichtung (1) ferner Mittel (4) zum selektiven Verbinden des Ausgangs des Differenzverstärkers (2) mit seinem invertierenden Eingang (V-) während einer vorgegebenen Vorladezeitdauer umfaßt.

2. Vorrichtung (1) nach Anspruch 1, **dadurch gekennzeichnet**, daß die selektiven Verbindungsmittel (4) Umschaltmittel umfassen, die durch ein zyklisches Vorladetaktsignal (CK) gesteuert werden.

3. Vorrichtung (1) nach Anspruch 2, **dadurch gekennzeichnet**, daß sie ferner hinter dem Differenzverstärker (2) angeordnete Verstärkungsmittel (3) mit hoher Impedanz umfaßt, um aus dem vom Differenzverstärker (2) ausgegebenen Erfassungssignal ($S_A$) eine logische Leseinformation (D) zu erzeugen.

4. Verfahren zum Erfassen des Inhalts von Zellen eines Speichers (M), insbesondere vom EPROM-Typ, angewandt in der Vorrichtung (1) nach einem der vorhergehenden Ansprüche, das für jede Sequenz des Lesens einer Zelle einen Schritt des Vorladens dieser Vorrichtung umfaßt, gefolgt von einem Schritt des Lesens des Inhalts der Zelle, der einen Vergleich eines in der Zelle fließenden Lesestroms ($I_L$) mit einem Referenzstrom ($I_{REF}$) umfaßt, wobei der Vergleich durch einen Differenzverstärker (2) durchgeführt wird, **dadurch gekennzeichnet,** daß während des Vorladeschritts der Differenzverstärker (2) während eines Vorladetaktzyklus in einen Nachfolgemodus geschaltet wird.

5. Verfahren nach Anspruch 4, **dadurch gekennzeichnet,** daß während des Vorladetaktzyklus der Ausgang des Differenzverstärkers (2) mit dem invertierenden Eingang (V-) des Differenzverstärkers (2) verbunden ist.

6. Löschbarer Festwehrspeicher (M), insbesondere vom EPROM-Typ, in den Vorrichtungen (20, 21) nach einem der Ansprüche 1 bis 3 integriert sind, **dadurch gekennzeichnet,** daß er Steuermittel (22) umfaßt zum Erzeugen eines Signals (CK) im Laufe eines Vorladetaktzyklus zum Steuern der Mittel zum selektives Verbinden des Ausgangs und des invertierenden Eingangs des Differenzverstärkers (2) einer jeden Erfassungsvorrichtung (1).

7. Löschbarer Festwehrspeicher (M), insbesondere vom EPROM-Typ, mit Mitteln zum Lesen einer Zelle, **dadurch gekennzeichnet,** daß diese Mittel das Verfahren nach einem der Ansprüche 4 oder 5 einsetzen.

**Claims**

1. Device (1) for detecting the content of the cells of a memory (M), notably an EPROM memory, these cells being organised in a set of bit lines, the device comprising means for comparing a reference current ($I_{REF}$) associated with a reference column ($C_{REF}$) and a read current ($I_L$) called down in a cell of a bit line and whose content is to be read, the said comparison means comprising a reference resistive element ($R_{REF}$) and a reading resistive element ($R_L$) through which respectively the said reference and read currents pass, and which are connected on the one hand to a supply voltage source ($V_{DD}$) and on the other hand respectively to a non-inverting input (V+) and to an inverting input (V-) of a differential amplifier (2) delivering at its output a detection signal ($S_A$), characterised in that the device (1) also comprises means (4) for selectively connecting the output of the differential amplifier (4) to its inverting input (V-) for a predetermined precharge period.

2. Device (1) according to Claim 1, characterised in that the selective connection means (4) comprises switching means controlled by a cyclic precharging clock signal (CK).

3. Device (1) according to Claim 2, characterised in that it also comprises high-impedance amplification means (3) placed downstream of the differential amplifier (2) for generating, from the detection signal ($S_A$) emitted by the said differential amplifier (2), a logic reading information item (D).

4. Method for detecting the content of cells of a memory (M), notably of the EPROM type, implemented in the device (1) according to one of the preceding claims, comprising, for each cell reading sequence, a step of precharging this device (1), followed by a step of reading the content of the said cell comprising a comparison of a read current ($I_L$) flowing in the said cell with a reference current ($I_{REF}$), this comparison being performed by a differential amplifier (2), characterised in that, during the precharge step, the differential amplifier (2) is switched into follower mode during a precharging clock cycle.

5. Method according to Claim 4, characterised in that, during the precharging clock cycle, the output of the differential amplifier (2) is connected to the inverting input (V-) of the said differential amplifier (2).

6. Erasable permanent memory (M), notably of the EPROM type, integrating the devices (20, 1) according to one of Claims 1 to 3, characterised in that it comprises control means (22) for generating, during a precharging clock cycle, a signal (CK) for controlling the means for selectively connecting the output and the inverting input of the differential amplifier (2) of each of the detection devices (1).

7. Erasable permanent memory (M), notably of the EPROM type, equipped with means of reading a cell, characterised in that the said means use the method in accordance with one of Claims 4 or 5.

FIG. 1

FIG. 2

FIG. 3